# EUROPEAN PATENT APPLICATION

(11) **EP 4 648 276 A2**
(43) Date of publication of application: **12.11.2025**
(21) Application number: 25205142.0
(22) Date of filing: 26.09.2025
(51) Int. Cl.: H02S 30/10, H10F 19/80

(54) **PHOTOVOLTAIC MODULE**

(30) Priority: 31.07.2025 CN 202521618936 U; 31.07.2025 CN 202511067541
(71) Applicant: JINKO SOLAR CO., LTD, ShangRao, Jiangxi 334100 (CN); Zhejiang Jinko Solar Co., Ltd., Haining, Zhejiang 314416 (CN)
(72) Inventor: CHEN, Zhendong, JIANGXI, 334100 (CN); TAO, Wusong, JIANGXI, 334100 (CN); LI, Tingting, JIANGXI, 334100 (CN)
(74) Representative: Haseltine Lake Kempner LLP

(57) **Abstract**

A photovoltaic module includes a lamination member, an insulation member and a frame, the insulation member is arranged at an edge of the lamination member, the insulation member is in contact with the insulation member in a first direction, and the edge of the lamination member is located in the frame. The lamination member includes a cell layer, and in a plane perpendicular to a thickness direction of the lamination member, a minimum distance between the cell layer and the insulation member is a, a minimum distance between the cell layer and the insulation member in the thickness direction of the lamination member is b, a part of the lamination member shielded by the insulation member in the thickness direction thereof has a size c in the first direction, and a creepage distance of the photovoltaic module is A=a+b+c.

## Description

### TECHNICAL FIELD

The present invention relates to the technical field of solar cells, and in particular, to a photovoltaic module.

### BACKGROUND

Photovoltaic module usually includes a lamination member and a frame clamping and fixing an edge of the lamination member. A solar cell is arranged in the lamination member and is configured to convert light energy into electric energy. In a plane perpendicular to a thickness direction of the lamination member, a shortest path between the solar cell and the frame is a creepage distance of the photovoltaic module.

In a use process, the creepage distance of the photovoltaic module needs to be greater than a preset value, so that a distance between the solar cell and the frame is large, which may influence a number of the provided solar cells, thereby influencing a photoelectric conversion efficiency of the photovoltaic module, and also influencing an overall size of the photovoltaic module.

Therefore, how to balance relationships between the creepage distance and the number of the solar cells and the overall size of the photovoltaic module is an important problem to be solved in the art.

### SUMMARY

According to some embodiments of the present invention, a photovoltaic module is provided, which can have a safe creepage distance, and meanwhile increase a number of solar cells and reduce an overall size of the photovoltaic module.

The present invention provides a photovoltaic module, including a lamination member, an insulation member and a frame. The lamination member includes a cell layer, the insulation member is arranged at an edge of the lamination member, and the edge of the lamination member is located in the frame. At least a part of the insulation member is in contact with the insulation member in a first direction, and in the first direction, the cell layer is located in a projection contour of the insulation member, and the first direction is perpendicular to a thickness direction of the lamination member. In a plane perpendicular to the thickness direction of the lamination member, a minimum distance between the cell layer and the insulation member is a, and 4.2mm≤a≤13mm.

In some embodiments, along an outer contour of the lamination member, a minimum distance between the cell layer and the insulation member in the thickness direction of the lamination member is b. A part of the lamination member shielded by the insulation member in the thickness direction thereof has a size c in the first direction. The creepage distance of the photovoltaic module is A, and 10.4mm≤A=a+b+c.

In the present invention, the insulation member is provided, and when the creepage distance A is larger than or equal to 10.4mm, a distance between the cell layer and the insulation member in a direction perpendicular to a thickness direction of the photovoltaic module can be reduced, that is, a distance between the cell layer and the edge of the lamination member can be reduced, so that the number of the solar cells contained in the cell layer can be increased to improve output power of the photovoltaic module, and a size of the photovoltaic module in the direction perpendicular to the thickness direction thereof can be reduced to reduce a processing cost of the photovoltaic module.

In some embodiments, a part of a light facing surface of the lamination member shielded by the frame in the thickness direction thereof has a size B in the first direction, and B≤a.

In some embodiments, the lamination member includes a light facing surface and a backlight surface arranged along the thickness direction thereof. A part of the light facing surface shielded by the insulation member in the thickness direction of the lamination member has a size c1 in the first direction, and c1≥0. A part of the backlight surface shielded by the insulation member in the thickness direction of the lamination member has a size c2 in the first direction, and c2≥0. When c1<c2, c=c1, when c2<c1, c=c2, and when c1=c2, c=c1=c2.

In some embodiments, c1≤a.

In some embodiments, when c1>0, B≤c1, such that a part of the insulation member extends out of the frame in the first direction.

In some embodiments, the insulation member includes an insulation layer and a water blocking layer, and the water blocking layer covers at least an exposed surface of the insulation layer.

In some embodiments, the water blocking layer has a thickness H1, and 1µm≤H1≤30µm.

In some embodiments, when c1>0, c1<B, such that the insulation member is located within a cavity of the frame.

In some embodiments, the frame includes a frame body and a first bonding layer, the first bonding layer is located between the frame body and the insulation member, and the frame body and the insulation member are bonded and fixed by the first bonding layer.

In some embodiments, in the thickness direction of the lamination member, a part of the first bonding layer extends towards the lamination member and contacts the lamination member, so as to cause the first bonding layer to shield the insulation member in the first direction.

In some embodiments, the insulation member includes at least an insulation layer and a second bonding layer, and the insulation layer and the lamination member are bonded and fixed by the second bonding layer.

In some embodiments, the insulation layer has a thickness H2, and 300µm≤H2≤400µm. The second bonding layer has a thickness H3, and 10µm≤H3≤100µm.

In some embodiments, in the plane perpendicular to the thickness direction of the lamination member, the lamination member includes at least a first side wall, a second side wall, a third side wall, and a fourth side wall that are sequentially arranged along a circumferential direction thereof. The insulation member at least includes a first side portion, a second side portion, a third side portion, and a fourth side portion, the first side portion is in contact with the first side wall, the second side portion is in contact with the second side wall, the third side portion is in contact with the third side wall, and the fourth side portion is in contact with the fourth side wall. The first side portion, the second side portion, the third side portion, and the fourth side portion are integrally formed.

In some embodiments, in the plane perpendicular to the thickness direction of the lamination member, the lamination member includes at least a first side wall, a second side wall, a third side wall, and a fourth side wall that are sequentially arranged along a circumferential direction thereof. The insulation member at least includes a first side portion, a second side portion, a third side portion, and a fourth side portion, the first side portion is in contact with the first side wall, the second side portion is in contact with the second side wall, the third side portion is in contact with the third side wall, and the fourth side portion is in contact with the fourth side wall. The first side portion, the second side portion, the third side portion, and the fourth side portion are separated structures, and a splicing gap is formed between the adjacent side portions.

It is to be understood that both the foregoing general description and the following detailed description are exemplary only and are not intended to limit the present invention.

### BRIEF DESCRIPTION OF THE DRAWINGS

To better describe the technical solutions in embodiments of the present invention, the following briefly describes the accompanying drawings required for the embodiments. Apparently, the accompanying drawings in the following description show merely some embodiments of the present invention, and a person of ordinary skill in the art may still derive other drawings from these accompanying drawings without creative efforts.
FIG. 1 is a schematic diagram of a light facing surface of a photovoltaic module according to some embodiments of the present invention;
FIG. 2 is a partial sectional view of the photovoltaic module according to a first embodiment of the present invention;
FIG. 3 is a sectional view of a lamination member in some embodiments of the present invention;
FIG. 4 is a schematic diagram of a connection structure of a cell layer in some embodiments of the present invention;
FIG. 5 is a partial sectional view of the photovoltaic module according to a second embodiment of the present invention;
FIG. 6 is a partial sectional view of the photovoltaic module according to a third embodiment of the present invention;
FIG. 7 is a partial sectional view of the photovoltaic module according to a fourth embodiment of the present invention;
FIG. 8 is a partial sectional view of the photovoltaic module according to a fifth embodiment of the present invention;
FIG. 9 is a partial sectional view of the photovoltaic module according to a sixth embodiment of the present invention;
FIG. 10 is a schematic sectional view of an insulation member in some embodiments;
FIG. 11 is a schematic sectional view of the insulation member in some other embodiments;
FIG. 12 is a schematic diagram of a connection structure of the lamination member and the insulation member in some embodiments;
FIG. 13 is a schematic diagram of the connection structure of the lamination member and the insulation member in some other embodiments; and
FIG. 14 is a schematic diagram of the connection structure of the lamination member and the insulation member in some other embodiments.

Reference signs:
1-lamination member; 11-cover plate; 111-first cover plate; 112-second cover plate; 12-packaging layer; 121-first packaging layer; 122-second packaging layer; 13-cell layer; 131-solar cell; 132-solder strip; 133-busbar; 14-light facing surface; 15-backlight surface; 16-first side wall; 17-second side wall; 18-third side wall; 19-fourth side wall; 2-frame; 21-frame body; 22-first bonding layer; 221-extending portion; 3-insulation member; 31-insulation layer; 32-water blocking layer; 33-second bonding layer; 34-first side portion; 35-second side portion; 36-third side portion; 37-fourth side portion; 38-splicing gap.

### DETAILED DESCRIPTION

In order to better understand the technical solution of the present invention, embodiments of the present invention are described in detail below with reference to the accompanying drawings.

It should be clear that the described embodiments are merely some but not all of the embodiments of the present invention. All other embodiments obtained by a person of ordinary skill in the art based on the embodiments of the present invention without creative efforts shall fall within the protection scope of the present invention.

The terminology used in embodiments of the present invention is for the purpose of describing particular embodiments only and is not intended to limit the present invention. As used in embodiments of the present invention and the appended claims, "a" and "the" in singular forms mean including plural forms, unless clearly indicated in the context otherwise.

It should be understood that the term "and/or" as used herein is merely an association relationship describing associated objects, indicating that three relationships may exist. For example, A and/or B indicates that there are three cases of A alone, A and B together, and B alone. In addition, the character "/" herein generally means that associated objects before and after "/"are in an "or" relationship.

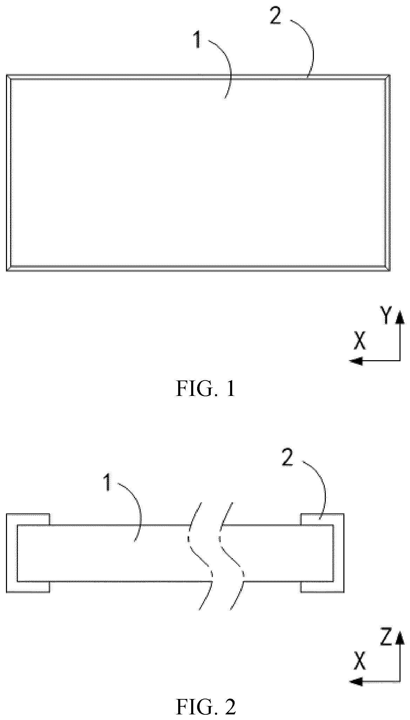

An embodiment of the present invention provides a photovoltaic module, and FIG. 1 is a schematic diagram of a light facing surface of the photovoltaic module according to some embodiments. Referring to FIG. 1, a first direction X and a second direction Y are shown, both the first direction X and the second direction Y are perpendicular to a thickness direction of the photovoltaic module. In some embodiments, the first direction X is a length direction of the photovoltaic module, and the second direction Y is a width direction of the photovoltaic module.

FIG. 2 is a partial sectional view of the photovoltaic module according to some embodiments. Referring to FIG. 1 and FIG. 2 together, the photovoltaic module includes a lamination member 1 and a frame 2 clamping and fixing an edge of the lamination member 1, so that the edge of the lamination member 1 is located within the frame 2. The frame 2 is configured to mount the lamination member 1 on the ground, a building, a bracket, or the like, and the frame 2 can protect the edge of the lamination member 1 and reduce the risk of damage of the edge of the lamination member 1 due to stress, so as to prolong a service life of the photovoltaic module.

FIG. 2 shows a third direction Z, and the third direction Z is parallel to the thickness direction of the photovoltaic module, that is, the first direction X, the second direction Y, and the third direction Z are perpendicular to each other.

In a plane defined by the first direction X and the third direction Z, a sectional shape of the frame 2 may be C-shaped, or may be other general frame shape, that is, a specific structure of the frame is not particularly limited in the embodiment of the present invention.

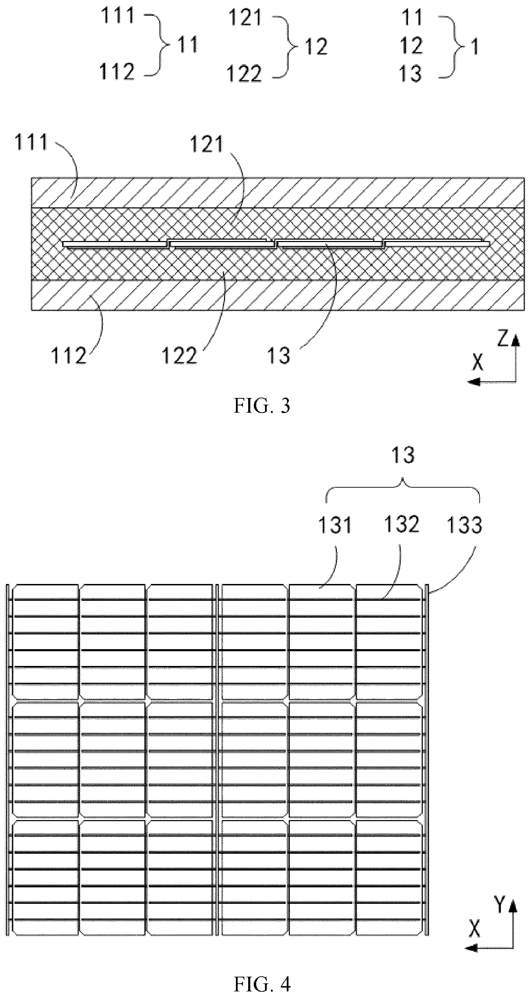

FIG. 3 is a sectional view of the lamination member in some embodiments. As shown in FIG. 3, the lamination member 1 includes a cover plate 11, a packaging layer 12, and a cell layer 13. The packaging layer 12 is located between the cover plate 11 and the cell layer 13 along the third direction Z, and the packaging layer 12 is configured to package and fix the cover plate 11 and the cell layer 13.

The cover plate 11 includes a first cover plate 111 and a second cover plate 112 arranged along the third direction Z. The packaging layer 12 and the cell layer 13 are located between the first cover plate 111 and the second cover plate 112. One part of the packaging layer 12 is located between the cell layer 13 and the first cover plate 111, and the other part of the packaging layer 12 is located between the cell layer 13 and the second cover plate 112, so as to package and fix the cover plate 11 and the cell layer 13.

At least one of the first cover plate 111 and the second cover plate 112 is made of a light-transmitting material, which is beneficial to improving a photoelectric conversion efficiency of the photovoltaic module.

The first cover plate 111 may be made of rigid materials, such as one of tempered glass, polyethylene terephthalate (PET), and polycarbonate (PC). Alternatively, the material of the first cover plate 111 may be one of flexible materials such as polyvinyl fluoride (PVF), an ethylene-tetra-fluoro-ethylene (ETFE) copolymer, and polyvinylidene fluoride (PVDF). The above materials have high light transmittance, and can ensure that more light irradiates the cell layer, thereby increasing light absorption of the photovoltaic module and improving the photoelectric conversion efficiency of the photovoltaic module.

The second cover plate 112 may be made of rigid materials, such as one of tempered glass, polyethylene terephthalate (PET), and polycarbonate (PC). Alternatively, the material of the second cover plate 112 may be one of flexible materials such as polyvinyl fluoride (PVF), an ethylene-tetra-fluoro-ethylene (ETFE) copolymer, and polyvinylidene fluoride (PVDF).

The materials of the first cover plate 111 and the second cover plate 12 may be the same or different.

With continued reference to FIG. 3, the packaging layer 12 includes a first packaging layer 121 and a second packaging layer 122. Along the third direction Z, a part of the first packaging layer 121 is located between the cell layer 13 and the first cover plate 111, and a part of the second packaging layer 122 is located between the cell layer 13 and the second cover plate 112.

The first packaging layer 121 is made of polyolefin, such as one of an ethylenevinyl acetate (EVA) copolymer, a polyolefin elastomer (POE), and polyvinyl butyral (PVB), and the above materials have high light transmittance, which is beneficial to improving the photoelectric conversion efficiency of the photovoltaic module. The first packaging layer 121 may also be an EPE adhesive film (EVA-POE-EVA co-extrusion structure) or an EP adhesive film (EVA-POE co-extrusion structure).

The second packaging layer 122 is made of polyolefin, such as one of an ethylenevinyl acetate (EVA) copolymer, a polyolefin elastomer (POE), and polyvinyl butyral (PVB). The second packaging layer 122 may also be an EPE adhesive film (EVA-POE-EVA co-extrusion structure) or an EP adhesive film (EVA-POE co-extrusion structure).

The materials of the first packaging layer 121 and the second packaging layer 122 may be the same or different.

FIG. 4 is a schematic diagram of a connection structure of the cell layer in some embodiments. As shown in FIG. 4, the cell layer 13 includes a plurality of solar cells 131. Adjacent two adjacent solar cells 131 are connected by a solder strip 132. The solder strips 132 can connect a plurality of solar cells 131 in series, so as to form a solar cell string. The adjacent solar cell strings are electrically connected by busbars 133, so that the plurality of solar cell strings are connected in series or in parallel to improve a performance of the photovoltaic module.

The type of the solar cell 131 includes, but is not limited to, a passivated emitter rear cell (PERC), a tunnel oxide passivated contact (TOPCon) cell, a heterojunction with intrinsic thin-film (HJT) cell, an interdigitated back contact (IBC) cell, a perovskite cell, or the like.

In a thickness direction of the PERC, the PERC sequentially includes a front surface metal silver electrode, a front surface silicon nitride passivation layer, a phosphorus layer emitter, a P-type substrate silicon layer, a local aluminum back surface field, a metal aluminum back electrode and a back passivation layer (Al₂O₃/SiNₓ). In the PERC, a passivation film is adopted to passivate a back surface, and an all-aluminum back surface field is replaced, thus enhancing internal back reflection of light on a silicon substrate, reducing a recombination rate of the back surface, and improving an efficiency of the solar cell by 0.5% to 1%.

In a thickness direction of the TOPCon cell, the TOPCon cell sequentially includes a metal silver electrode, a front surface silicon nitride passivation layer, a boron-doped emitter, an N-type substrate silicon layer, a diffusion doping layer, ultra-thin silicon oxide, doped polycrystalline silicon, silicon nitride and a metal silver electrode. A back surface of the cell is composed of a layer of ultra-thin silicon oxide (1 nm-2 nm) and a layer of phosphorus-doped microcrystalline amorphous mixed Si film, and the ultra-thin silicon oxide and the phosphorus-doped microcrystalline amorphous mixed Si film form a passivation contact structure together. The structure can block minority carrier hole recombination and improve an open-circuit voltage and a short-circuit current of the solar cell. An ultra-thin oxide layer can allow majority carrier electrons to tunnel into a polycrystalline silicon layer while blocking the minority carrier hole recombination. A silicon wafer surface energy band is bent due to a good passivation effect of the ultra-thin silicon oxide and a heavily doped silicon film, so that a field passivation effect is achieved, an electron tunneling probability is greatly increased, a contact resistance is reduced, and the open-circuit voltage and the short-circuit current of the solar cell are increased, thereby improving a conversion efficiency of the solar cell.

In a thickness direction of the HJT cell, the HJT cell sequentially includes a front low-temperature silver electrode, a front conductive film, an N-type amorphous silicon film, an intrinsic amorphous silicon film, an N-type substrate silicon layer, an intrinsic amorphous silicon film, a P-type amorphous silicon film, a back conductive film and a back low-temperature silver electrode.

In a thickness direction of the IBC cell, the IBC cell sequentially includes a silicon nitride reflection layer, an N+ front surface field, an N-type substrate silicon layer, a P+ emitter, an N+ back surface field, an aluminum oxide passivation layer, a silicon nitride antireflection layer and a metal silver electrode. In the IBC cell, a P region and an N region which have good uniformity and precisely controllable junction depths can be obtained by using an ion implantation technology, a front surface of the solar cell is not shielded by electrodes, a shading current loss of a metal electrode can be eliminated, maximum utilization of incident photons is realized, and the short-circuit current can be improved by about 7% compared with a conventional solar cell. Due to a back contact structure, an electrode shielding problem does not need to be considered, and an electrode proportion can be properly widened, thereby reducing a series resistance and realizing a high filling factor. Surface passivation and surface light trapping structures can be subjected to an optimized design, and a lower front surface recombination rate and lower surface reflection can be obtained.

In a thickness direction of the perovskite cell, the perovskite cell sequentially includes a substrate material, a conductive film, an electron transport layer (titanium dioxide), a perovskite absorption layer (hole transport layer) and a metal cathode. A perovskite material has a high light absorption coefficient and a long carrier diffusion distance, and after photons absorbed by the perovskite material are converted into electrons, the electrons can be easily collected by an electrode, and a loss is small, so that a high photogenerated voltage and current can be generated, and perovskite shows a high photoelectric conversion efficiency.

The embodiments of the present invention do not specifically limit the specific type of the solar cell 131.

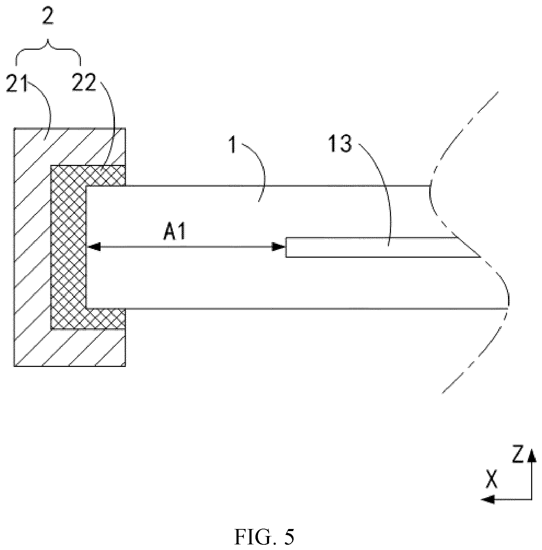

FIG. 5 is a partial sectional view of the photovoltaic module according to some embodiments of the present invention. As shown in FIG. 5, the frame 2 includes a frame body 21 and a first bonding layer 22. The first bonding layer 22 is located between the frame body 21 and the lamination member 1, and the first bonding layer 22 is configured to bond and fix the frame body 21 and the lamination member 1.

A creepage distance of the photovoltaic module refers to a shortest path between two conductive parts or between a conductive part and a device protection interface measured along an insulation surface. The creepage distance is one of important conditions for evaluating the performance of the photovoltaic module, and if the creepage distance is insufficient, electric leakage tracking or arc discharging is easily caused, and then, a cell performance and a safety performance of the photovoltaic module are influenced.

According to IEC standards, a system voltage and a minimum creepage distance of the photovoltaic module need to meet a certain corresponding relationship. In some embodiments, when the system voltage of the photovoltaic module is 1,500V and a pollution class is class 1, the minimum creepage distance of the photovoltaic module is 10.4mm. That is, the creepage distance should be greater than 10.4mm.

In the photovoltaic module shown in FIG. 5, the creepage distance A1 of the photovoltaic module refers to a shortest straight-line distance between the cell layer 13 and the frame 2 in a plane perpendicular to the third direction Z. In some embodiments, as shown in FIG. 5, the creepage distance A1 may be understood as a shortest straight-line distance between the cell layer 13 and an outer edge of the lamination member 1 in the first direction X, that is, A1 needs to be equal to or greater than 10.4mm.

Based on the structure shown in FIG. 5, if the creepage distance A1 is desired to be further increased, a distance between the cell layer 13 and the frame 2 in the first direction X, i.e., a distance between the cell layer 13 and the outer edge of the lamination member 1, should be increased.

When an overall size of the photovoltaic module is a preset determined value, a number of the solar cells included in the cell layer 13 is reduced, thereby reducing the output power of the photovoltaic module.

When the output power of the photovoltaic module and the number of the provided solar cells included in the cell layer 13 are determined values, the overall size of the photovoltaic module is increased.

Therefore, the structure of the photovoltaic module needs to be adjusted to balance the relationships between the creepage distance and the number of the solar cells and the overall size of the photovoltaic module.

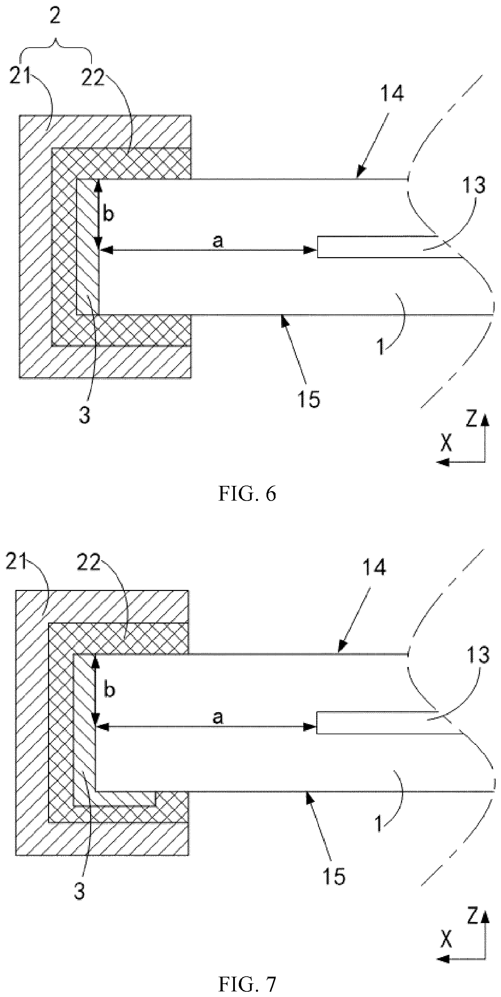

FIG. 6 is a partial sectional view of the photovoltaic module according to some embodiments of the present invention. As shown in FIG. 6, the photovoltaic module further includes an insulation member 3, and the insulation member 3 is located between the frame 2 and the lamination member 1. That is, the insulation member 3 is arranged at the edge of the lamination member 1. At least a part of the insulation member 3 is in contact with the insulation member 3 in the first direction X, and the cell layer 13 is located within a projection contour of the insulation member 3 in the first direction X.

In this case, an assembly method of the photovoltaic module includes:
S1, attaching the insulation member 3 to the edge of the lamination member 1;
S2, filling the frame body 21 with connection adhesive to form the first bonding layer 22; and
S3, placing the edge of the lamination member 1 into the frame 2 to cause at least a part of the structure of the insulation member 3 to be located inside the frame 2, so that the frame 2 clamps and fixs an outer side of the insulation member 3.

In the embodiment of the present invention, the sequence of the step S1 and the step S2 is not particularly limited, and it is possible to perform the step S1 first and then perform the step S2, or perform the step S2 first and then perform the step S1, or perform the step S1 and the step S2 at the same time.

As shown in FIG. 6, in the plane perpendicular to the third direction Z, a minimum distance between the cell layer 13 and the insulation member 3 is a. For convenience of description, as an example, the cell layer 13 and the insulation member 3 have the minimum distance a in the first direction X.

As shown in FIG. 6, along an outer contour of the lamination member 1, a minimum distance between the cell layer 13 and the insulation member 3 in the third direction Z is b.

A part of the lamination member 1 shielded by the insulation member 3 in the third direction Z has a size c in the first direction X, and c≥0. When c=0, at least one side of the lamination member 1 is not shielded by the insulation member 3; when c>0, both sides of the lamination member 1 are shielded by the insulation member 3. FIG. 6 illustrates the case where both sides of the lamination member 1 are not shielded by the insulation member 3, and in this case, c=0.

As shown in FIG. 6, the creepage distance of the photovoltaic module is A, A=a+b+c, and A≥10.4mm.

In some embodiments, the insulation member 3 is arranged between the frame 2 and the lamination member 1, so that the creepage distance A is at least a sum of a and b. When the creepage distance A is greater than or equal to 10.4mm, the minimum distance between the cell layer 13 and the insulation member 3 in the plane perpendicular to the third direction Z can be reduced, that is, the distance between the cell layer 13 and the edge of the lamination member 1 can be reduced, so as to increase the number of the solar cells included in the cell layer 13 to increase the output power of the photovoltaic module. A size of the photovoltaic module in a direction perpendicular to the third direction Z can also be reduced to reduce a processing cost of the photovoltaic module.

In some embodiments, 4.2mm≤a≤13mm. For example, the minimum distance a between the cell layer 13 and the insulation member 3 in the first direction X may be 4.2mm, 5mm, 6mm, 7mm, 8mm, 9mm, 10mm, 11mm, 12mm, 13mm, or the like.

If the minimum distance between the cell layer 13 and the insulation member 3 in the first direction X is too small, on the basis that the creepage distance A is not less than 10.4mm, a size of shielding of the lamination member 1 by the insulation member 3 needs to be increased, that is, a material cost of the insulation member 3 is increased, so that an overall cost of the photovoltaic module is increased.

If the minimum distance between the cell layer 13 and the insulation member 3 in the first direction X is too large, the distance between the cell layer 13 and the outer edge of the lamination member 1 is too large, which affects the number of the provided solar cells and the overall size of the photovoltaic module.

Therefore, 4.2mm≤a≤13mm, so that the size of shielding of the lamination member 1 by the insulation member 3 can be reduced to reduce the costs of the insulation member 3 and the photovoltaic module, the distance between the cell layer 13 and the outer edge of the lamination member 1 can also be reduced, so as to increase the number of the solar cells contained in the cell layer 13 to increase the output power of the photovoltaic module, and the overall size of the photovoltaic module can also be reduced.

In some embodiments, 4.2mm≤a≤5mm, and the minimum distance a between the cell layer 13 and the insulation member 3 in the first direction X may be 4.2mm, 4.25mm, 4.3mm, 4.35mm, 4.4mm, 4.45mm, 4.5mm, 4.55mm, 4.6mm, 4.65mm, 4.7mm, 4.75mm, 4.8mm, 4.85mm, 4.9mm, 4.95mm, 5mm, or the like.

In some embodiments, 5mm≤a≤7mm, and the minimum distance a between the cell layer 13 and the insulation member 3 in the first direction X may be 5mm, 5.2mm, 5.4mm, 5.6mm, 5.8mm, 6mm, 6.2mm, 6.4mm, 6.6mm, 6.8mm, 7mm, or the like.

In some embodiments, 7mm≤a≤9mm, and the minimum distance a between the cell layer 13 and the insulation member 3 in the first direction X may be 7mm, 7.2mm, 7.4mm, 7.6mm, 7.8mm, 8mm, 8.2mm, 8.4mm, 8.6mm, 8.8mm, 9mm, or the like.

In some embodiments, 9mm≤a≤11mm, and the minimum distance a between the cell layer 13 and the insulation member 3 in the first direction X may be 9mm, 9.2mm, 9.4mm, 9.6mm, 9.8mm, 10mm, 10.2mm, 10.4mm, 10.6mm, 10.8mm, 11mm, or the like.

In some embodiments, 11mm≤a≤13mm, and the minimum distance a between the cell layer 13 and the insulation member 3 in the first direction X may be 11mm, 11.2mm, 11.4mm, 11.6mm, 11.8mm, 12mm, 12.2mm, 12.4mm, 12.6mm, 12.8mm, 13mm, or the like.

The lamination member 1 includes a light facing surface and a backlight surface which are arranged along the third direction. A part of the light facing surface shielded by the insulation member in the third direction has a size c1 in the first direction, and c1≥0. A part of the backlight surface shielded by the insulation member in the third direction has a size c2 in the first direction, and c2≥0.

When c1<c2, c used for calculating the creepage distance is c1, that is, c=c1. When c2<c1, c used for calculating the creepage distance is c2, that is, c=c2. When c=c2, c used for calculating the creepage distance is c1 and c2, that is, c=c1=c2.

Several cases of c are separately discussed below.

In some embodiments, with continued reference to FIG. 6, the insulation member 3 covers only the sides of the lamination member 1, the insulation member 3 does not shield both the light facing surface 14 and the backlight surface 15 of the lamination member 1, and in this case, c=0.

FIG. 7 is a partial sectional view of the photovoltaic module according to some other embodiments. As shown in FIG. 7, the light facing surface 14 of the lamination member 1 is not shielded by the insulation member 3, the backlight surface 15 of the lamination member 1 is shielded by the insulation member 3, and in this case, c for calculating the creepage distance is still 0.

When the light facing surface 14 of the lamination member 1 is shielded by the insulation member 3, and the backlight surface 15 is not shielded by the insulation member 3, c for calculating the creepage distance is still 0.

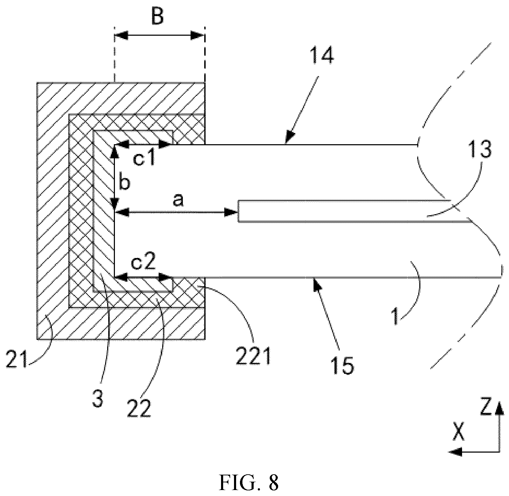

FIG. 8 is a partial sectional view of the photovoltaic module according to some other embodiments. As shown in FIG. 8, both the light facing surface 14 and the backlight surface 15 of the lamination member 1 are shielded by the insulation member 3, the size of the part of the light facing surface 14 shielded by the insulation member 3 in the first direction X is c1, the size of the part of the backlight surface 15 shielded by the insulation member 3 in the first direction X is c2, the smaller one of c1 and c2 is c for calculating the creepage distance. When c1 and c2 are equal, any one of c1 and c2 is c for calculating the creepage distance.

In summary, when the insulation member 3 is cut along the plane defined by the first direction X and the third direction Z, the obtained sectional shape of the insulation member 3 may be a rectangle shape shown in FIG. 6, an L shape shown in FIG. 7, or a U shape shown in FIG. 8.

With continued reference to FIG. 8, in one embodiment, c1≤a, so as to reduce the risk that the insulation member 3 shields the cell layer 13, reduce the risks of output power reduction, local temperature rise, or the like, caused by shielding the cell layer 13, and then improve the performance of the photovoltaic module.

With continued reference to FIG. 8, in one embodiment, a part of the light facing surface 14 of the lamination member 1 shielded by the frame 2 in the third direction Z has a size B in the first direction X.

As shown in FIG. 8, B≤a, so as to reduce the risk that the frame 2 shields the cell layer 13, reduce the risks of output power reduction, local temperature rise, or the like, caused by shielding the cell layer 13, and then improve the performance of the photovoltaic module.

A structure of the lamination member 1 on the light facing surface 14 is taken as an example. When c1<B, as shown in FIG. 8, a part of the first bonding layer 22 extends along the third direction Z to form an extending portion 221. The extending portion 221 is in contact with the light facing surface 14 of the lamination member 1, and the extending portion 221 is in contact with the insulation member 3 in the first direction X, such that the insulation member 3 is located in a cavity of the frame 2. The first bonding layer 22 shields the insulation member 3 in the first direction X, thereby reducing the risk of partial exposure of the insulation member 3, and reducing the risks of aging and damage of the insulation member 3, so as to prolong a service life of the insulation member 3, and improve working stability of the photovoltaic module.

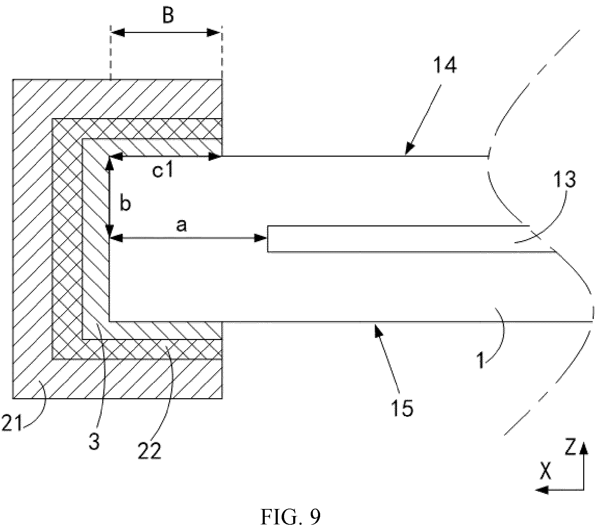

FIG. 9 is a partial sectional view of the photovoltaic module according to some embodiments. As shown in FIG. 9, when c1≥B, a part of the insulation member 3 extends to an outer side of the frame 2 along the first direction X, so that a part of the insulation member 3 is exposed, and the creepage distance can be increased while shielding of the frame 2 to the lamination member 1 is reduced.

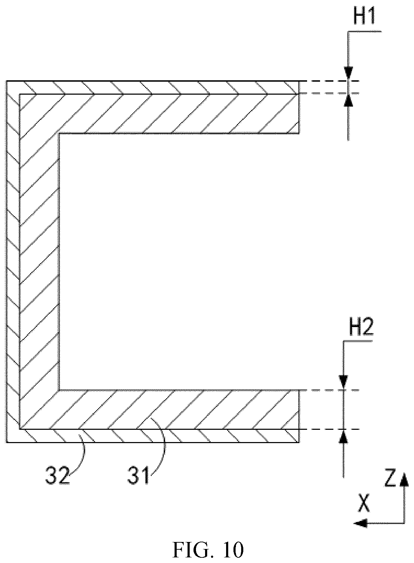

FIG. 10 is a schematic sectional view of the insulation member 3 in some embodiments. As shown in FIG. 10, the insulation member 3 includes an insulation layer 31 and a water blocking layer 32, and the water blocking layer 32 covers at least an exposed surface of the insulation layer 31.

In some embodiments, a surface of the insulation layer 31 is covered by the water blocking layer 32, so that risks of aging, failure, damage, or the like, of the insulation layer 31 caused by exposure of the insulation layer 31 in an external environment are reduced, and risks of aging, short circuit, or the like, of the solar cell caused by external water vapor entering the lamination member 1 are also reduced, thereby improving the working stability of the photovoltaic module.

As shown in FIG. 10, the water blocking layer 32 has a thickness H1, and 1µm≤H1≤30µm. In some embodiments, the thickness of the water blocking layer 32 may be 1µm, 5µm, 10µm, 15µm, 20µm, 25µm, 30µm, or the like.

If the thickness of the water blocking layer 32 is too small, processing difficulty of the water blocking layer 32 is too large, and the water blocking layer 32 is prone to be broken.

If the thickness of the water blocking layer 32 is too large, a cost of the water blocking layer 32 is too high, and an overall size of the insulation member is too large.

Therefore, 1µm≤H1≤30µm, so that the cost of the water blocking layer 32 can be reduced to reduce the costs of the insulation member and the photovoltaic module, the overall sizes of the insulation member and the photovoltaic module can be reduced, the processing difficulty of the water blocking layer 32 can be reduced to reduce the processing costs of the insulation member and the photovoltaic module, processing periods of the insulation member and the photovoltaic module can be shortened, a production efficiency can be improved, strength of the water blocking layer 32 can be improved, and the risk of damage of the water blocking layer 32 in the processes of processing, assembling, transporting, or the like, is reduced.

In some embodiments, 1µm≤H1≤10µm, and the thickness of the water blocking layer 32 may be 1µm, 2µm, 3µm, 4µm, 5µm, 6µm, 7µm, 8µm, 9µm, 10µm, or the like.

In some embodiments, 10µm≤H1≤20µm, and the thickness of the water blocking layer 32 may be 10µm, 11µm, 12µm, 13µm, 14µm, 15µm, 16µm, 17µm, 18µm, 19µm, 20µm, or the like.

In some embodiments, 20µm≤H1≤30µm, and the thickness of the water blocking layer 32 may be 20µm, 21µm, 22µm, 23µm, 24µm, 25µm, 26µm, 27µm, 28µm, 29µm, 30µm, or the like.

With continued reference to FIG. 10, the insulation layer 31 has a thickness H2, and 300µm≤H2≤400µm. In some embodiments, the thickness of the insulation layer 31 may be 300µm, 310µm, 320µm, 330µm, 340µm, 350µm, 360µm, 370µm, 380µm, 390µm, 400µm, or the like.

If the thickness of the insulation layer 31 is too small, processing difficulty of the insulation layer 31 is too large.

If the thickness of the insulation layer 31 is too large, a material cost of the insulation layer 31 is too high, and an overall size of the insulation member is too large.

Therefore, 300µm≤H2≤400µm, so that the material cost of the insulation layer 31 can be reduced to reduce the costs of the insulation member and the photovoltaic module, the processing difficulty of the insulation layer 31 can be reduced to reduce the processing costs of the insulation member and the photovoltaic module, the processing periods of the insulation member and the photovoltaic module can be shortened, and the production efficiency can be improved.

In some embodiments, 300µm≤H2≤320µm, and the thickness of the insulation layer 31 may be 300µm, 301µm, 302µm, 303µm, 304µm, 305µm, 306µm, 307µm, 308µm, 309µm, 310µm, 311µm, 312µm, 313µm, 314µm, 315µm, 316µm, 317µm, 318µm, 319µm, 320µm, or the like.

In some embodiments, 320µm≤H2≤340µm, and the thickness of the insulation layer 31 may be 320µm, 321µm, 322µm, 323µm, 324µm, 325µm, 326µm, 327µm, 328µm, 329µm, 330µm, 331µm, 332µm, 333µm, 334µm, 335µm, 336µm, 337µm, 338µm, 339µm, 340µm, or the like.

In some embodiments, 340µm≤H2≤360µm, and the thickness of the insulation layer 31 may be 340µm, 341µm, 342µm, 343µm, 344µm, 345µm, 346µm, 347µm, 348µm, 349µm, 350µm, 351µm, 354µm, 353µm, 354µm, 355µm, 356µm, 357µm, 358µm, 359µm, 360µm, or the like.

In some embodiments, 360µm≤H2≤380µm, and the thickness of the insulation layer 31 may be 360µm, 361µm, 362µm, 363µm, 364µm, 365µm, 366µm, 367µm, 368µm, 369µm, 370µm, 371µm, 374µm, 373µm, 374µm, 375µm, 376µm, 377µm, 378µm, 379µm, 380µm, or the like.

In some embodiments, 380µm≤H2≤400µm, and the thickness of the insulation layer 31 may be 380µm, 381µm, 382µm, 383µm, 384µm, 385µm, 386µm, 387µm, 388µm, 389µm, 390µm, 391µm, 394µm, 393µm, 394µm, 395µm, 396µm, 397µm, 398µm, 399µm, 400µm, or the like.

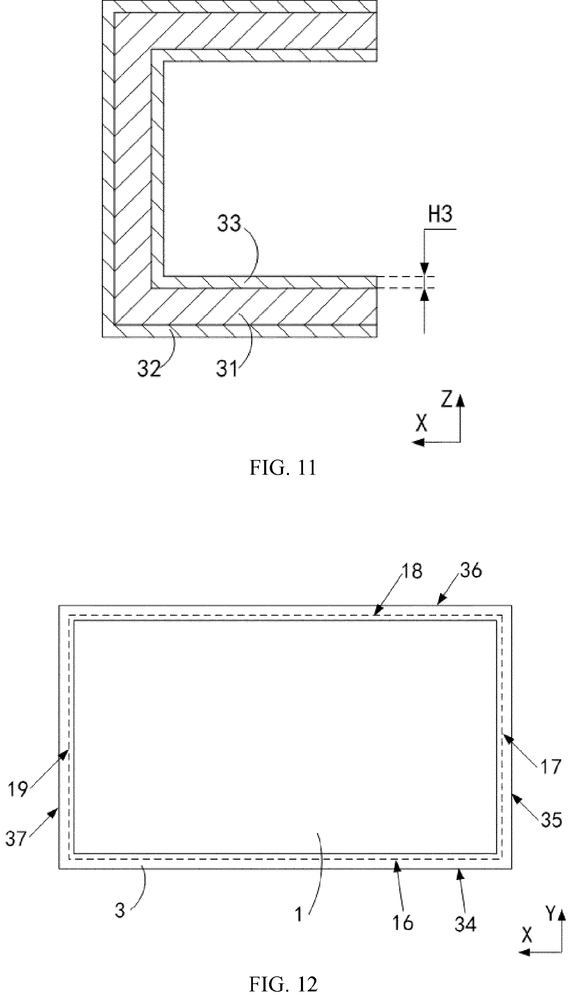

FIG. 11 is a schematic sectional view of the insulation member in some other embodiments. As shown in FIG. 11, the insulation member 3 further includes a second bonding layer 33, and the insulation layer 31 and the lamination member 1 are bonded and fixed by the second bonding layer 33.

In some embodiments, the insulation member 3 is bonded and fixed on the lamination member 1 through the second bonding layer 33, which simplifies a connection manner of the insulation member and the lamination member, and is beneficial to reducing connection difficulty of the insulation member and the lamination member 1, thereby being beneficial to shortening an assembly period of the photovoltaic module to improve the production efficiency.

As shown in FIG. 11, the second bonding layer 33 has a thickness H3, and 10µm≤H3≤100µm. In some embodiments, the thickness of the second bonding layer 33 may be 10µm, 20µm, 30µm, 40µm, 50µm, 60µm, 70µm, 80µm, 90µm, 100µm, or the like.

If the thickness of the second bonding layer 33 is too small, processing difficulty of the second bonding layer 33 is too large.

If the thickness of the second bonding layer 33 is too large, a material cost of the second bonding layer 33 is too high, and overall thicknesses of the insulation member and the photovoltaic module are too large.

Therefore, 10µm≤H3≤100µm, so that the material cost of the second bonding layer 33 can be reduced to reduce the costs of the insulation member and the photovoltaic module, the processing difficulty of the second bonding layer 33 can be reduced to reduce the processing costs of the insulation member and the photovoltaic module, the processing periods of the insulation member and the photovoltaic module can be shortened, and the production efficiency can be improved.

In some embodiments, 10µm≤H3≤20µm, and the thickness of the second bonding layer 33 may be 10µm, 11µm, 12µm, 13µm, 14µm, 15µm, 16µm, 17µm, 18µm, 19µm, 20µm, or the like.

In some embodiments, 20µm≤H3≤40µm, and the thickness of the second bonding layer 33 may be 20µm, 21µm, 22µm, 23µm, 24µm, 25µm, 26µm, 27µm, 28µm, 29µm, 30µm, 31µm, 32µm, 33µm, 34µm, 35µm, 36µm, 37µm, 38µm, 39µm, 40µm, or the like.

In some embodiments, 40µm≤H3≤60µm, and the thickness of the second bonding layer 33 may be 40µm, 41µm, 42µm, 43µm, 44µm, 45µm, 46µm, 47µm, 48µm, 49µm, 50µm, 51µm, 52µm, 53µm, 54µm, 55µm, 56µm, 57µm, 58µm, 59µm, 60µm, or the like.

In some embodiments, 60µm≤H3≤80µm, and the thickness of the second bonding layer 33 may be 60µm, 61µm, 62µm, 63µm, 64µm, 65µm, 66µm, 67µm, 68µm, 69µm, 70µm, 71µm, 72µm, 73µm, 74µm, 75µm, 76µm, 77µm, 78µm, 79µm, 80µm, or the like.

In some embodiments, 80µm≤H3≤100µm, and the thickness of the second bonding layer 33 may be 80µm, 81µm, 82µm, 83µm, 84µm, 85µm, 86µm, 87µm, 88µm, 89µm, 90µm, 91µm, 92µm, 93µm, 94µm, 95µm, 96µm, 97µm, 98µm, 99µm, 100µm, or the like.

FIG. 12 is a schematic diagram of a connection structure of the lamination member and the insulation member in some embodiments, and the outer edge of the lamination member is illustrated with dotted lines in FIG. 12. As shown in FIG. 12, in the plane perpendicular to the third direction Z, the lamination member 1 includes a first side wall 16, a second side wall 17, a third side wall 18, and a fourth side wall 19 that are sequentially arranged along a circumferential direction thereof. As shown in FIG. 12, the insulation member 3 includes a first side portion 34, a second side portion 35, a third side portion 36, and a fourth side portion 37. The first side portion 34 is in contact with the first side wall 16, the second side portion 35 is in contact with the second side wall 17, the third side portion 36 is in contact with the third side wall 18, and the fourth side portion 37 is in contact with the fourth side wall 19.

In some embodiments, as shown in FIG. 12, the first side portion 34, the second side portion 35, the third side portion 36, and the fourth side portion 37 are integrally formed.

In the assembly process of the photovoltaic module, one end of the whole insulation member 3 is attached to the edge of the lamination member 1, and attachment of the insulation member 3 on the surface of the lamination member 1 can be completed by pulling the insulation member 3 to circle the lamination member 1 along the edge of the lamination member 1, thus lowering attachment difficulty.

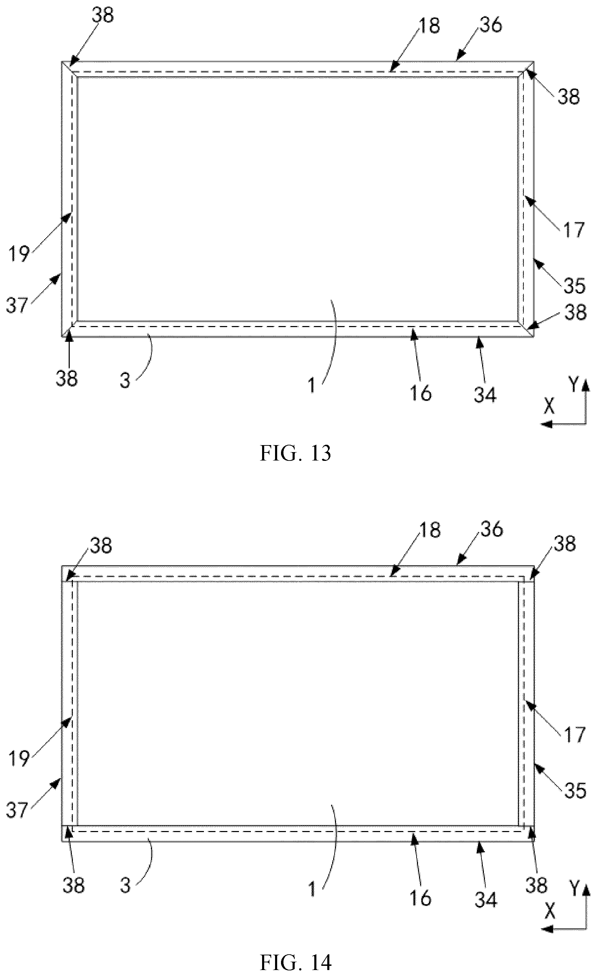

FIG. 13 is a schematic diagram of the connection structure of the lamination member and the insulation member in some other embodiments. As shown in FIG. 13, the first side portion 34, the second side portion 35, the third side portion 36, and the fourth side portion 37 are separated structures, and splicing gaps 38 are formed between the adjacent side portions.

The splicing gap 38 may be parallel to the first direction X, may be parallel to the second direction Y, or may form included angles relative to both the first direction X and the second direction Y.

FIG. 13 illustrates the case that an extension direction of the splicing gap 38 forms included angles of 45° relative to both the first direction X and the second direction Y.

In the assembly method of the photovoltaic module, the insulation member 3 can be cut into four pieces with 45-degree oblique angles according to a preset size, and then, the four pieces are attached to the four side walls of the lamination member 1, respectively.

Alternatively, firstly, the whole insulation member 3 is attached to one first side wall 16 of the lamination member 1, the insulation member 3 is then cut off, the rest of the insulation member 3 is then attached to the second side wall 17 of the lamination member 1, the insulation member 3 is cut off, the rest of the insulation member 3 is attached to the third side wall 18 of the lamination member 1, the insulation member 3 is cut off again, and then, the rest of the insulation member 3 is attached to the fourth side wall 19 of the lamination member 1, thus completing the attachment of the insulation member 3 on the four side walls of the lamination member 1.

FIG. 14 is a schematic diagram of the connection structure of the lamination member and the insulation member in some other embodiments. FIG. 14 illustrates the case that the extension direction of the splicing gap 38 is parallel to the first direction X.

In this case, the manner of attachment of the insulation member 3 at the edge of the lamination member 1 is the same as that of the structure shown in FIG. 13, and is not repeated herein.

In some embodiments, the insulation member 3 is cut into four parts with specific sizes and specific angles, and then, the four parts are respectively attached to the four side walls of the lamination member 1, so that the risk that the insulation member 3 wrinkles at corners of the lamination member 1 is reduced, so as to improve flatness of the attachment of the insulation member 3 to the surface of the lamination member 1.

In addition, when the insulation member 3 has the splicing gap 38, the risk that external water vapor enters the lamination member through the splicing gap 38 is high, and in this case, the packaging layer at the splicing gap 38 can be configured as a waterproof adhesive film to reduce the risks of aging, short circuit, or the like, of the solar cell caused by invading of the water vapor into the solar cell, so as to improve the performance of the photovoltaic module and prolong the service life of the photovoltaic module.

Although the respective embodiments have been described one by one, it shall be appreciated that the respective embodiments will not be isolated. Those skilled in the art can apparently appreciate upon reading the invention of this application that the respective technical features involved in the respective embodiments can be combined arbitrarily between the respective embodiments as long as they have no collision with each other. Of course, the respective technical features mentioned in the same embodiment can also be combined arbitrarily as long as they have no collision with each other.

## Claims

1. A photovoltaic module, comprising:
a lamination member (1) comprising a cell layer (13);
an insulation member (3) arranged at an edge of the lamination member (1), at least a part of the insulation member (3) being in contact with the insulation member (3) in a first direction (X), in the first direction (X), the cell layer (13) being located in a projection contour of the insulation member (3), and the first direction (X) being perpendicular to a thickness direction (Z) of the lamination member (1); and
a frame (2), the edge of the lamination member (1) being located in the frame (2);
wherein in a plane perpendicular to the thickness direction (Z) of the lamination member (1), a minimum distance between the cell layer (13) and the insulation member (3) is a, and 4.2mm ≤a≤13mm.

2. The photovoltaic module according to claim 1, wherein along an outer contour of the lamination member (1), a minimum distance between the cell layer (13) and the insulation member (3) in the thickness direction (Z) of the lamination member (1) is b;
wherein a part of the lamination member (1) shielded by the insulation member (3) in the thickness direction (Z) thereof has a size c in the first direction (X);
wherein a creepage distance of the photovoltaic module is A, and 10.4mm≤A=a+b+c; wherein a part of a light facing surface (14) of the lamination member (1) shielded by the frame (2) in the thickness direction (Z) thereof has a size B in the first direction (X), and B≤a.

3. The photovoltaic module according to claim 1, wherein the lamination member (1) comprises a light facing surface (14) and a backlight surface (15) arranged along the thickness direction (Z) thereof;
wherein a part of the light facing surface (14) shielded by the insulation member (3) in the thickness direction (Z) of the lamination member (1) has a size c1 in the first direction (X), and c1≥0;
wherein a part of the backlight surface (15) shielded by the insulation member (3) in the thickness direction (Z) of the lamination member (1) has a size c2 in the first direction (X), and c2≥0;
when c1<c2, then c=c1;
when c2<c1, then c=c2;
when c1=c2, then c=c1=c2.

4. The photovoltaic module according to claim 3, wherein c1≤a.

5. The photovoltaic module according to claim 3, wherein when c1>0, then B≤c1, such that a part of the insulation member (3) extends out of the frame (2) along the first direction (X).

6. The photovoltaic module according to claim 5, wherein the insulation member (3) comprises an insulation layer (31) and a water blocking layer (32), and the water blocking layer (32) covers at least an exposed surface of the insulation layer (31).

7. The photovoltaic module according to claim 6, wherein the water blocking layer (32) has a thickness H1, and 1µm≤H1≤30µm.

8. The photovoltaic module according to claim 3, wherein when c1>0, then c1<B, such that the insulation member (3) is located within a cavity of the frame (2).

9. The photovoltaic module according to claim 8, wherein the frame (2) comprises a frame body (21) and a first bonding layer (22), the first bonding layer (22) is located between the frame body (21) and the insulation member (3), and the frame body (21) and the insulation member (3) are bonded and fixed by the first bonding layer (22).

10. The photovoltaic module according to claim 9, wherein in the thickness direction (Z) of the lamination member (1), a part of the first bonding layer (22) extends towards the lamination member (1) and is in contact with the lamination member (1), such that the first bonding layer (22) shields the insulation member (3) in the first direction (X).

11. The photovoltaic module according to claim 9, wherein the insulation member (3) comprises an insulation layer (31) and a second bonding layer (33), and the insulation layer (31) and the lamination member (1) are bonded and fixed by the second bonding layer (33).

12. The photovoltaic module according to claim 11, wherein the insulation layer (31) has a thickness H2, and 300µm≤H2≤400µm;
the second bonding layer (33) has a thickness H3, and 10µm≤H3≤100µm.

13. The photovoltaic module according to claim 1, wherein in the plane perpendicular to the thickness direction (Z) of the lamination member (1), the lamination member (1) comprises a first side wall (16), a second side wall (17), a third side wall (18), and a fourth side wall (19) that are sequentially arranged along a circumferential direction thereof;
wherein the insulation member (3) comprises a first side portion (34), a second side portion (35), a third side portion (36), and a fourth side portion (37), the first side portion (34) is in contact with the first side wall (16), the second side portion (35) is in contact with the second side wall (17), the third side portion (36) is in contact with the third side wall (18), and the fourth side portion (37) is in contact with the fourth side wall (19).

14. The photovoltaic module according to claim 13, wherein the first side portion (34), the second side portion (35), the third side portion (36), and the fourth side portion (37) are integrally formed.

15. The photovoltaic module according to claim 13, wherein the first side portion (34), the second side portion (35), the third side portion (36), and the fourth side portion (37) are separated structures, and a splicing gaps (38) is formed between adjacent side portions.
